# FASCICULE DE BREVET EUROPEEN

(11) **EP 4 180 551 B1**
(45) Date de publication et mention de la délivrance du brevet: **02.04.2025**
(21) Numéro de dépôt: 22206423.0
(22) Date de dépôt: 09.11.2022
(51) Int. Cl.: C23C 14/34, C23C 14/54, C23C 14/56, C23C 16/44

(54) **DISPOSITIF DE DEPOT PHYSIQUE EN PHASE VAPEUR, COMPRENANT UN SYSTEME DE RUPTURE DE COURT-CIRCUIT**
PHYSIKALISCHE DAMPFABSCHEIDUNGSVORRICHTUNG MIT KURZSCHLUSSUNTERBRECHUNGSSYSTEM
PHYSICAL VAPOR DEPOSITION DEVICE INCLUDING A SHORT CIRCUIT BREAKING SYSTEM

(30) Priorité: 12.11.2021 FR 2112004
(43) Date de publication de la demande: 17.05.2023
(73) Titulaire: Commissariat à l'Energie Atomique et aux Energies Alternatives, 75015 Paris (FR)
(72) Inventeur: GAILLARD, Sébastien, 38054 Grenoble Cedex 09 (FR); BARBERO, William, 38054 Grenoble Cedex 09 (FR); JANIN, Rémi, 38054 Grenoble Cedex 09 (FR)
(74) Mandataire: Brevalex

(56) Documents cités:
- EP-A1- 0 776 990
- US-A1- 2014 131 193
- US-A1- 2015 345 007
- US-A1- 2015 371 847

## Description

### DOMAINE TECHNIQUE

L'invention concerne le domaine des dépôts physiques en phase vapeur, également dénommés dépôts PVD (de l'anglais *« Physical Vapor Deposition »*), et par exemple connus du document US 2015/0371847 A1.

Elle concerne plus particulièrement le traitement d'un cas de court-circuit électrique entre une cible située dans une chambre de dépôt, et le fond de cette chambre de dépôt, en cas de chute accidentelle d'un substrat.

L'invention trouve de nombreuses applications, par exemple dans le domaine de la fabrication de cellules photovoltaïques, ou encore dans tout autre secteur de l'industrie micro-électronique.

### ETAT DE LA TECHNIQUE ANTERIEURE

De manière connue, un dépôt physique en phase vapeur PVD est un procédé de recouvrement d'une surface d'un substrat par des atomes ou des molécules d'un matériau à déposer, qui viennent adhérer sur le substrat à recouvrir en passant par un milieu passif (vide ou atmosphère inerte) ou actif (plasma, gaz réactif).

Globalement, un dispositif de dépôt PVD comprend une chambre de dépôt dans laquelle une ou plusieurs cibles sont alimentées électriquement, tandis que la paroi délimitant la chambre est reliée à la masse. Dans le cas où le dépôt est prévu pour être réalisé sur une surface du substrat orientée vers le bas, c'est-à-dire faisant face au fond de chambre, les cibles sont généralement agencées entre le substrat et ce même fond de chambre, à proximité de ce dernier.

De par cette configuration des éléments à l'intérieur de la chambre, il existe un risque que le substrat tombe accidentellement de son support, et se retrouve en contact simultanément avec l'une des cibles et le fond de chambre. Il en résulte un court-circuit, susceptible d'endommager la cible concernée.

Lorsqu'un tel événement accidentel se produit, la seule solution actuellement connue pour y remédier consiste à ouvrir la chambre de dépôt, puis à procéder au retrait du substrat tombé, avant de nettoyer la cible affectée. Néanmoins, ce principe requiert la mise en œuvre de nombreuses opérations chronophages, parmi lesquelles l'arrêt du procédé de dépôt, l'arrêt des pompes turbo-moléculaires et de la ventilation de la chambre, l'ouverture de la chambre pour enlever manuellement le substrat tombé, le nettoyage de la cible, la refermeture de la chambre, la remise sous vide et l'application d'un test de fuite, la requalification de l'équipement, etc. Au total, ce principe nécessite une durée d'intervention d'au moins 9 heures, voire bien plus encore lorsque le problème apparait après un dépôt important déjà réalisé dans la chambre. Dans ce cas, un changement des tôles de protection de la chambre peut être nécessaire, et il implique une durée additionnelle d'intervention d'au moins 24 heures, durant lesquelles le dispositif de dépôt PVD doit rester à l'arrêt.

Il existe par conséquent un besoin d'optimisation de la gestion des cas de court-circuit dans les chambres des dispositifs de dépôt PVD.

### RESUME DE L'INVENTION

Pour répondre à ce besoin, l'invention a pour objet un dispositif de dépôt physique en phase vapeur, comprenant une chambre de dépôt en partie délimitée par un fond de chambre, le dispositif comprenant en outre, logés dans la chambre :
- des moyens de support de substrat ; et
- au moins une cible agencée dans une partie basse de la chambre, entre les moyens de support de substrat et le fond de chambre en rapport à une direction de la hauteur du dispositif de dépôt.

Selon l'invention, le dispositif de dépôt comporte en outre un système de rupture de court-circuit susceptible d'être provoqué par un substrat tombé et se trouvant en position de court-circuit en contact simultané avec la cible et le fond de chambre, le système de rupture de court-circuit comprenant une structure d'appui sur le/les éventuels substrats tombés en position de court-circuit, ainsi que des moyens de mise en mouvement de la structure d'appui dans un espace situé entre le fond de chambre et la cible.

De façon analogue, l'invention a également pour objet un procédé de rupture d'un court-circuit dans un tel dispositif de dépôt, le procédé comprenant la mise en mouvement de la structure d'appui dans l'espace situé entre le fond de chambre et la cible, de manière à venir contacter le substrat en position de court-circuit puis à le déplacer / le casser, de sorte qu'il ne se trouve plus en contact simultané avec la cible et le fond de chambre.

L'invention apporte ainsi une solution simple, efficace, et nécessitant un temps d'intervention particulièrement court pour rompre un court-circuit qui se serait produit suite à la tombée accidentelle d'un substrat dans le fond de chambre.

A titre indicatif, l'arrêt du procédé de dépôt, la mise en mouvement de la structure d'appui pour déplacer / casser le substrat tombé, puis le redémarrage du procédé, nécessitent une durée d'arrêt de la machine d'environ 1 heure. Cette durée d'arrêt s'avère par conséquent largement inférieure à celle requise avec la solution connue de l'art antérieur, ce qui génère un gain de productivité extrêmement important.

L'invention prévoit de préférence au moins l'une des caractéristiques techniques optionnelles suivantes, prises isolément ou en combinaison.

De préférence, ladite au moins une cible agencée en partie basse de la chambre correspond à une ou plusieurs cibles rotatives, de préférence selon un/des axes de rotation parallèles à un plan principal de fond de chambre. Cependant, l'emploi de cibles fixes reste envisageable dans le cadre de la présente invention.

De préférence, dans la direction de la hauteur, l'écartement entre ladite au moins une cible agencée en partie basse de la chambre, et le fond de chambre, est inférieur à 20 mm.

De préférence, la structure d'appui du système de rupture de court-circuit comprend une barre d'appui parallèle à un plan principal de fond de chambre. Toute autre forme de structure d'appui peut néanmoins être envisagée, sans sortir du cadre de l'invention.

De préférence, le fond de chambre est équipé d'au moins une rampe d'injection de gaz dans la chambre de dépôt, et la structure d'appui du système de rupture de court-circuit comprend, associée à chaque rampe d'injection de gaz, une portion d'appui destinée à être déplacée au-dessus de la rampe d'injection. Cela permet de supprimer tout court-circuit susceptible de se produire entre une cible, et une rampe d'injection de gaz également reliée à la masse en étant au contact du fond de chambre.

De préférence, les moyens de mise en mouvement sont conçus pour déplacer en translation la structure d'appui du système de rupture de court-circuit. Cependant, tout autre mouvement peut être envisagé, comme un mouvement circulaire, ou encore un mouvement plus complexe, mais qui permet préférentiellement de maintenir la structure d'appui dans un plan parallèle au plan principal de fond de chambre.

De préférence, les moyens de mise en mouvement comprennent un vérin pneumatique, de préférence télescopique. D'autres moyens de mise en mouvement peuvent être envisagés, comme d'autres types de vérins, ou encore une vis sans fin, un moteur linéaire avec un capot de protection, etc.

De préférence, le système de rupture de court-circuit comprend un dispositif de commande des moyens de mise en mouvement, le dispositif de commande étant actionnable par un opérateur. Ces moyens permettent donc à l'opérateur d'actionner manuellement le dispositif de commande, par exemple via un simple bouton marche/arrêt sur le dispositif de commande.

Alternativement ou simultanément, le dispositif de dépôt comprend un système de détection de court-circuit entre ladite au moins une cible agencée en partie basse de la chambre, et le fond de chambre, et ce système de détection est relié au système de rupture de court-circuit de manière à actionner automatiquement le dispositif de commande des moyens de mise en mouvement, en cas de détection de court-circuit.

De préférence, les moyens de support de substrat sont des moyens permettant de mettre des substrats en déplacement à l'intérieur de la chambre de dépôt. Alternativement, les moyens de support pourraient être conçus pour maintenir en position fixe les substrats dans la chambre de dépôt, sans sortir du cadre de l'invention.

De préférence, la chambre de dépôt comporte un premier compartiment dans lequel se trouve ladite au moins une cible agencée en partie basse de la chambre, ainsi qu'un second compartiment communiquant avec le premier et logeant au moins une cible agencée dans une partie haute de la chambre, les moyens de support de substrat étant agencés sous ladite au moins une cible agencée en partie haute de la chambre.

De préférence, ladite au moins une cible agencée en partie basse de la chambre fait partie intégrante d'un bloc cible amovible comprenant un capot supérieur de fermeture de la chambre de dépôt.

De préférence, le bloc cible comprend des supports de cibles agencés entre le capot supérieur de fermeture et la/les cibles agencées en partie basse de la chambre.

D'autres avantages et caractéristiques de l'invention apparaîtront dans la description détaillée non limitative ci-dessous.

### BREVE DESCRIPTION DES DESSINS

Cette description sera faite au regard des dessins annexés parmi lesquels ;
[Fig 1] est une vue schématique en coupe transversale d'un dispositif de dépôt PVD, selon un mode de réalisation préféré de l'invention ;
[Fig 2] est une vue en coupe prise le long de ligne II-II de la figure 1 ;
[Fig 3] est une vue agrandie d'une partie de la vue de la figure précédente, montrant un vérin pneumatique pour la mise en translation d'une structure d'appui d'un système de rupture de court-circuit ;
[Fig 4] représente une vue en perspective, plus détaillée, du vérin montré sur la figure précédente ;
[Fig 5] représente une vue en perspective, encore plus détaillée, d'une partie du vérin montré sur la figure précédente ;
[Fig 6] représente une vue en perspective d'un bloc cible comprenant des cibles destinées à se trouver en partie basse de la chambre de dépôt du dispositif de dépôt PVD montré sur les figures 1 et 2 ;
[Fig 7] représente une vue de face du bloc cible montré sur la figure précédente ;
[Fig 8] représente une vue en perspective d'une partie d'un plateau de maintien de substrats ; et
[Fig 9] représente une vue schématique de côté illustrant une étape de rupture de court-circuit entre le fond de chambre et l'une des cibles, suite à la tombée accidentelle d'un substrat.

### EXPOSE DETAILLE DE MODES DE REALISATION PREFERES

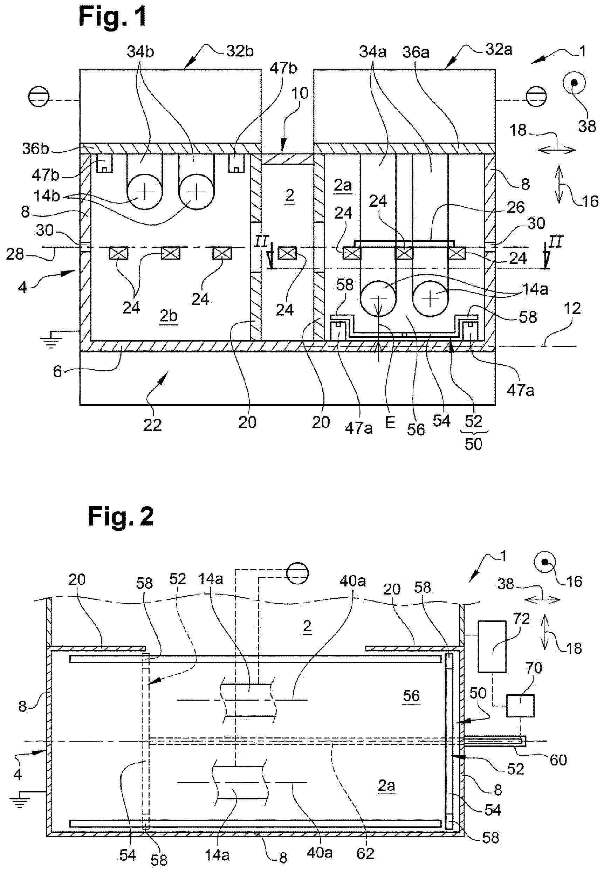

En référence aux figures 1 à 3, il est représenté un dispositif de dépôt PVD selon un mode de réalisation préféré de l'invention. Ce dispositif de dépôt se trouve adapté à de nombreuses applications, en particulier celle de la fabrication de cellules photovoltaïques. Néanmoins, d'autres applications sont possibles, notamment dans le domaine de l'industrie micro-électronique.

Le dispositif de dépôt PVD, portant la référence numérique 1 sur les figures, comporte principalement une chambre de dépôt 2 délimitée par une paroi 4. De par la forme sensiblement parallélépipédique de la chambre 2, la paroi 4 comporte un fond de chambre 6, des parois latérales 8, ainsi qu'une paroi supérieure 10. Le fond de chambre 6 s'inscrit dans un plan principal de fond de chambre 12, orienté horizontalement ou sensiblement horizontalement. Les parois latérales 8 sont orthogonales ou sensiblement orthogonales à ce plan 12, tandis que la paroi supérieure 10 est parallèle ou sensiblement parallèle à ce même plan principal de fond de chambre 12.

Dans ce mode de réalisation préféré, la chambre 2 définit un premier compartiment 2a, dans lequel se trouvent des cibles 14a agencées en partie basse de la chambre, en rapport à une direction de la hauteur 16 du dispositif 1. La chambre définit également un second compartiment 2b, dans lequel se trouvent des cibles 14b agencées en partie haute de la chambre. Les premier et second compartiments sont adjacents selon une direction transversale 18 du dispositif 1, et séparés l'un de l'autre par une ou plusieurs cloisons intermédiaires 20, de conception ajourée. De ce fait, les deux compartiments 2a, 2b communiquent l'un avec l'autre dans la direction transversale 18 du dispositif de dépôt, et la dépression appliquée au sein de la chambre 2 demeure ainsi la même au sein de chacun de ces deux compartiments 2a, 2b.

Des équipements 22 du dispositif 1 sont agencés sous le fond de chambre 2, et représentés uniquement schématiquement sur la figure 1. En outre, de manière classique et connue de l'homme du métier, les cibles 14a, 14b sont alimentées en courant continu, tandis que la paroi 4 de la chambre 2 est reliée à la masse.

Le dispositif 1 comporte également des moyens de support 24 des substrats 26 sur lesquels le dépôt doit être réalisé. Ces moyens de support 24 sont portés intérieurement par les parois latérales 8 de la chambre, et ils présentent une conception connue qui ne sera pas davantage décrite ici. Il est simplement indiqué que ces moyens de support 24 sont conçus pour permettre le déplacement des substrats 26 à l'intérieur de la chambre 2, le long d'un chemin de déplacement préférentiellement rectiligne et parallèle ou sensiblement parallèle à la direction transversale 18 du dispositif. Sur la figure 1, le chemin de déplacement des substrats 26 a été représenté schématiquement par la ligne pointillée 28, qui s'étend donc à travers les premier et second compartiments 2a, 2b, en passant par les parties ajourées des cloisons intermédiaires 20. A cet égard, il est indiqué que les deux parois latérales 8 situées aux extrémités opposées de la chambre, selon la direction transversale 18, sont équipées d'ouvertures étanches 30 pour respectivement l'introduction et l'extraction des substrats 26 dans et en dehors de la chambre 2. De cette manière, les substrats 26 peuvent par exemple pénétrer successivement dans plusieurs chambres de plusieurs dispositifs de dépôt PVD distincts, agencés en série.

Dans le premier compartiment 2a, selon la direction de la hauteur 16, les cibles 14a sont agencées entre les moyens de support 24 et le fond de chambre 6 près duquel se trouvent ces cibles 14a. D'ailleurs, il est prévu que l'écartement vertical « E » entre les cibles 14a et le fond de chambre 6 soit est inférieur à 20 mm, cet écartement E ayant été référencé sur la figure 1.

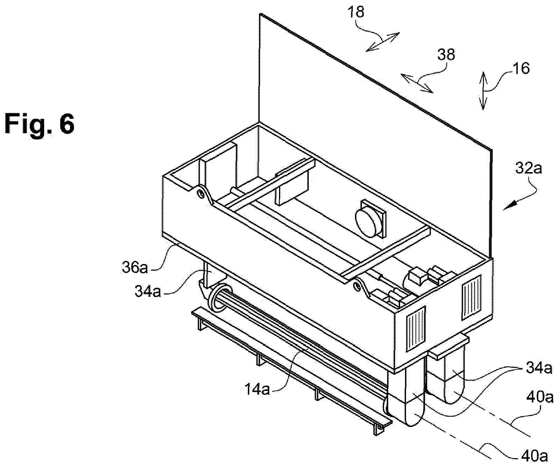

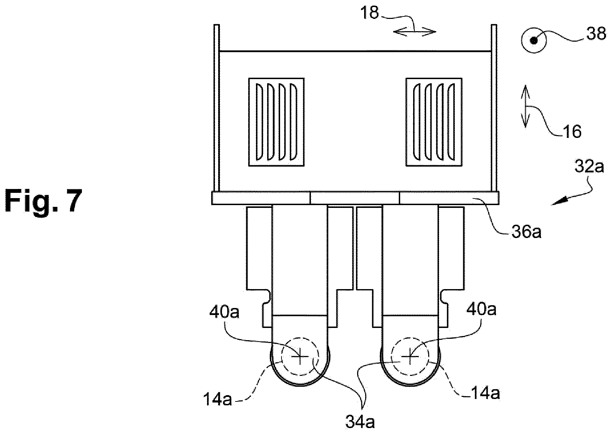

Le nombre de cibles 14a est ici de deux, mais il pourrait différer, sans sortir du cadre de l'invention. Ces cibles 14a sont intégrées à un premier bloc cible amovible 32a, également représenté sur les figures 6 et 7.

Le premier bloc cible amovible 32a comprend un capot supérieur 36a de fermeture du premier compartiment 2a, ce capot faisant ainsi partie intégrante de la paroi supérieure 10 délimitant la chambre de dépôt 2. Des supports de cibles verticaux 34a sont agencés entre le capot supérieur de fermeture 36a et les cibles 14a, en étant agencés aux extrémités du bloc 32a selon une direction 38 de la profondeur du dispositif 1, le long de laquelle s'étendent les cibles 14a. De cette manière, il ne se produit aucune interférence mécanique entre les supports verticaux 34a, et les substrats 26 en défilement au centre de la chambre 2, le long du chemin de déplacement 28.

Ici, les cibles 14a adoptent chacune une forme générale de cylindre de section circulaire, et elles sont rotatives selon des axes 40a parallèles entre eux, et parallèles ou sensiblement parallèles à la direction 38 et au plan principal de fond de chambre 12. Chacune des deux cibles 14a s'étend ainsi sur sensiblement toute la profondeur du premier compartiment 2a, selon la direction 38.

De manière analogue, les cibles 14b sont intégrées à un second bloc cible amovible 32b, comprenant un capot supérieur 36b de fermeture du second compartiment 2b, ce capot faisant donc également partie intégrante de la paroi supérieure 10 délimitant la chambre de dépôt 2. Des supports de cibles verticaux 34b, plus courts que les supports 34a, sont agencés entre le capot supérieur de fermeture 36b et les cibles 14b, en étant également agencés aux extrémités du bloc 32b selon la direction 38.

Avec la conception retenue, les cibles 14a situées en partie basse de la chambre 2, sous les moyens 24 de support de substrat, permettent le dépôt de matière sur la surface inférieure des substrats 26 en défilement dans le premier compartiment 2a, le long du chemin 28. Cette surface intérieure des substrats, orientée vers le fond de chambre 6, est également dénommée surface ou face arrière du substrat. A l'inverse, les cibles 14b situées en partie haute de la chambre 2, au-dessus des moyens 24 de support de substrat, permettent le dépôt de matière sur la surface opposée supérieure des substrats 26 en défilement dans le second compartiment 2b, toujours le long du chemin de déplacement 28. La surface supérieure des substrats, orientée vers la paroi supérieure 10 délimitant la chambre 2, est également dénommée surface ou face avant du substrat.

Le dispositif de dépôt PVD 1 est également équipé de plusieurs rampes d'injection de gaz 47a, 47b. En effet, dans le premier compartiment 2a, le fond de chambre 6 supporte deux rampes 47a d'injection de gaz inerte, situées respectivement aux deux extrémités opposées de ce compartiment 2a, selon la direction transversale 18. De la même manière, dans le second compartiment 2b, le capot supérieur 36b supporte deux rampes 47b d'injection de gaz inerte, situées respectivement aux deux extrémités opposées de ce compartiment 2b, selon la direction transversale 18.

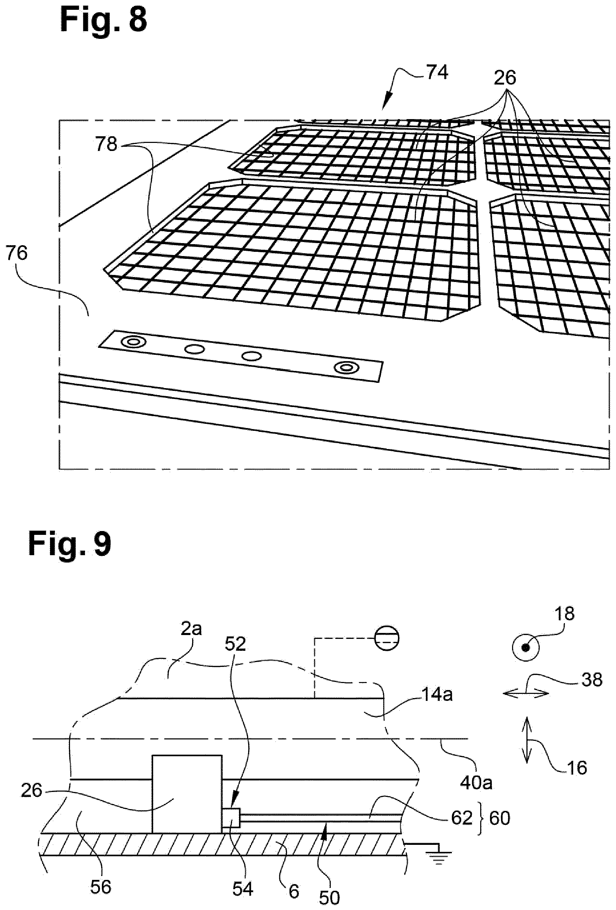

L'une des particularités de l'invention réside ici dans la mise en œuvre d'un système de rupture de court-circuit susceptible d'être provoqué par un substrat tombé 26, et se trouvant en position de court-circuit en contact simultané avec l'une des deux cibles 14a, et le fond de chambre 6. Une telle position de court-circuit est représentée schématiquement sur la figure 9. Dans cette position, il est en effet susceptible de se produire un court-circuit, correspondant à un champ électrique entre le fond de chambre 6 relié à la masse et la cible 14a alimentée en courant continue, ces deux éléments 14a, 6 se trouvant alors reliés électriquement par le substrat tombé 26.

Le système de rupture de court-circuit 50 comprend tout d'abord une structure 52 d'appui sur le/les éventuels substrats 26 tombés en position de court-circuit.

La structure d'appui 52 peut comprendre une barre d'appui 54 parallèle au plan principal de fond de chambre 12, et parallèle ou sensiblement parallèle à la direction transversale 18. Cette barre d'appui 54 s'étend de préférence sur environ toute la longueur transversale séparant les deux rampes d'injection de gaz 47a, en étant logée entre celles-ci, dans un espace 56 situé verticalement entre le fond de chambre 6 et les deux cibles 14a. La barre d'appui 54 est ici droite ou sensiblement droite, mais elle pourrait être remplacée par toute autre forme, par exemple une forme de V avec la pointe du V orientée vers l'avant dans la direction de déplacement de cette structure d'appui 52.

La structure d'appui 52 peut être complétée, à chacune des deux extrémités opposées de la barre d'appui 54, d'une portion d'appui 58 destinée à être déplacée au-dessus de sa rampe d'injection 47a associée. Chaque portion d'appui 58 prend préférentiellement la forme d'un décrochement vers le haut en extrémité de barre. Elle permet ainsi de traiter les éventuels cas de court-circuit créés par un substrat tombé et immobilisé accidentellement entre l'une des deux cibles 14a, et l'une des deux rampes d'injection de gaz 47a également reliée à la masse, via le fond de chambre 6.

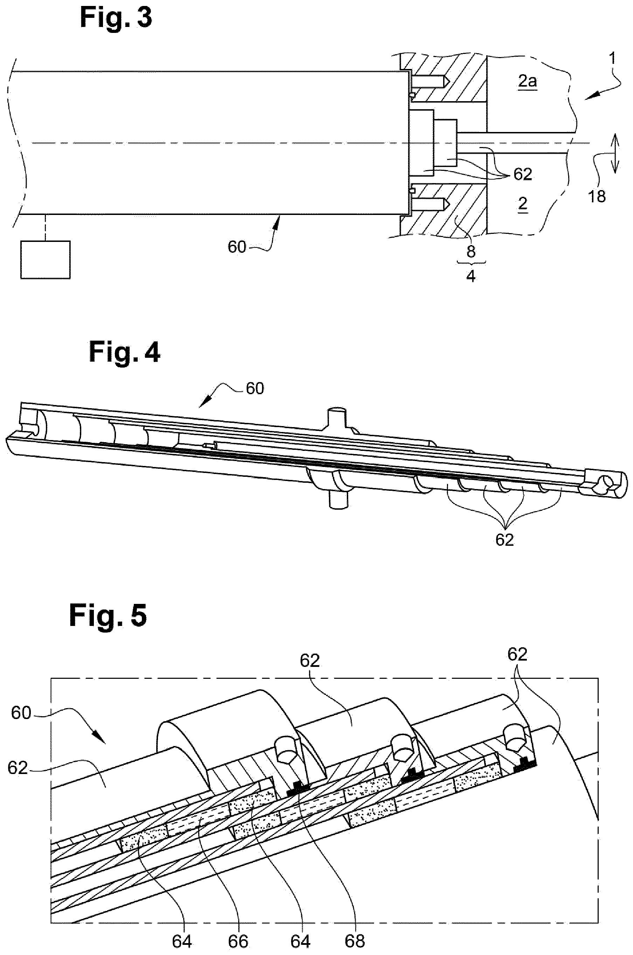

Pour que la structure d'appui 52 balaye tout l'espace 56, ou une grande partie de ce dernier, le système de rupture de court-circuit 50 est complété par des moyens 60 de mise en mouvement de la structure d'appui 52 dans cet espace 56. Les moyens de mise en mouvement 60 correspondent ici à des moyens permettant de déplacer la barre d'appui 54 en translation selon la direction 38, donc orthogonalement à l'axe propre de la barre 54, comme cela a été schématisé par la structure d'appui 52 en pointillés sur la figure 2. Pour ce faire, les moyens de mise en mouvement comprennent préférentiellement un vérin pneumatique 60, de conception télescopique pour limiter l'encombrement en dehors de la chambre 2. Ce vérin pneumatique 60, visible sur les figures 2 à 5, est porté par l'une des parois latérales 8, et il dispose d'un corps fixe agencé extérieurement à la chambre 2 sur cette paroi latérale 8. Celle-ci est traversée de manière étanche par les différentes sections de la tige de piston télescopique, ces sections étant référencées 62 sur les figures 3 à 5, et représentées uniquement de manière schématique en pointillés sur la figure 2, dans la position déployée. Entre les sections de tige 62, il est prévu des moyens d'étanchéité renforcés pour éviter d'éventuelles fuites de l'air de commande du vérin, vers l'intérieur de la chambre 2 en dépression. Ces moyens d'étanchéité comprennent par exemple, entre deux sections de tige quelconques 62 et directement consécutives, la succession axiale d'un joint plat 64, d'un liquide ferromagnétique 66, d'un autre joint plat 64, et enfin d'un joint racleur 68 qui se situe à l'extrémité de chaque section de tige 62.

Associé à ce vérin pneumatique 60, le système de rupture de court-circuit 50 comprend en outre un dispositif de commande 70 schématisé sur la figure 2. Ce dispositif de commande 70 du vérin 60 peut être actionné manuellement par un opérateur désirant supprimer un court-circuit accidentel au sein de la chambre de dépôt 2, par exemple via un simple bouton marche/arrêt intégré à ce dispositif de commande 70.

En complément, ou dans une réalisation alternative, l'actionnement du dispositif de commande 70 peut être effectué de manière automatique, après détection d'un court-circuit accidentel et potentiellement dommageable pour les cibles 14a.

Pour ce faire, le dispositif 1 peut comprendre un système 72 de détection de court-circuit entre l'une des deux cibles 14a et le fond de chambre 6, ce système pouvant adopter toute conception réputée appropriée. La détection peut d'ailleurs s'effectuer de manière directe ou indirecte. Par exemple, le système de détection 72 schématisé sur la figure 2 peut reposer sur le contrôle et le suivi de la puissance demandée au générateur de courant continu qui alimente les cibles 14a. En effet, il est possible de suivre la puissance délivrée par ce générateur, ainsi que la puissance perdue ou les fuites. Généralement cette puissance perdue est de l'ordre de 4 à 5 W en utilisation normale, mais lors d'un court-circuit provoqué par un substrat tombé accidentellement dans le fond de chambre, cette puissance peut atteindre 800 à 1 000 W. Ainsi, le vérin 60 peut être actionné automatiquement en fonction du signal fourni par le système de détection 72 au dispositif de commande 70. En d'autres termes, la solution proposée permet l'actionnement automatique du vérin 60, dès lors que la valeur de puissance perdue dépasse un seuil qui est prédéterminé de manière à éviter l'endommagement des cibles 14a.

Quelle que soit la nature de l'actionnement produit, manuel ou automatique, le dispositif de commande 70 engendre la sortie de la tige télescopique du vérin 60. Cela conduit la structure d'appui 52 à se déplacer en translation de manière à balayer tout l'espace 56 sous les cibles 54a, afin de casser / déplacer le/les substrats tombés accidentellement en position de court-circuit entre l'une des cibles 14a et le fond de chambre 6. En effet, lors d'un tel déplacement de la structure d'appui 52 schématisé sur la figure 9, l'entrée au contact de cette structure 52 avec le substrat tombé 26 conduit ce dernier à se casser, ou bien à se déstabiliser jusqu'à tomber à plat sur fond de chambre 6. Dans les deux cas, la rupture / suppression du court-circuit est obtenue de manière simple et satisfaisante, puisque le substrat 26 ne se trouve plus en contact simultané avec la cible 14a et le fond de chambre 6.

A cet égard, il est noté que les substrats 26 traités à l'intérieur de la chambre de dépôt 2 peuvent être placés directement sur les moyens de support 24 qui ont été décrits précédemment. Mais de manière plus habituelle et préférentielle, ces substrats 26 sont agencés au sein de plateaux de maintien (de l'anglais *« trays »*), qui sont eux-mêmes supportés par les moyens de support 24. Ces plateaux 74, dont l'un est représenté en partie sur la figure 8, servent donc de support intermédiaire entre les substrats 26 et les moyens de support 24 fixés aux parois latérales de la chambre 2. Toujours de manière connue, chaque plateau 74 comporte une armature 76 délimitant des orifices traversants 78, dans lesquels sont maintenus les substrats 26.

Enfin, il est précisé que la barre d'appui 54 peut être au contact de la surface intérieure du fond de chambre 6, de manière à exercer une fonction de racleur durant son mouvement dans l'espace inférieur 56 de la chambre 2. Alternativement, un jeu vertical peut être ménagé entre le fond de chambre 6 et cette barre d'appui 54.

Bien entendu, diverses modifications peuvent être apportées par l'homme du métier à l'invention qui vient d'être décrite, uniquement à titre d'exemples non limitatifs, et dont la portée est définie par les revendications annexées.

## Revendications

1. Dispositif (1) de dépôt physique en phase vapeur, comprenant une chambre de dépôt (2) en partie délimitée par un fond de chambre (6), le dispositif comprenant en outre, logés dans la chambre :
- des moyens de support de substrat (24) ; et
- au moins une cible (14a) agencée dans une partie basse de la chambre (2), entre les moyens de support de substrat (24) et le fond de chambre (6) en rapport à une direction de la hauteur (16) du dispositif de dépôt,
**caractérisé en ce qu'**il comporte en outre un système de rupture de court-circuit (50) susceptible d'être provoqué par un substrat (26) tombé et se trouvant en position de court-circuit en contact simultané avec la cible (14a) et le fond de chambre (6), le système de rupture de court-circuit (50) comprenant une structure (52) d'appui sur le/les éventuels substrats (26) tombés en position de court-circuit, ainsi que des moyens (60) de mise en mouvement de la structure d'appui (52) dans un espace (56) situé entre le fond de chambre (6) et la cible (14a).

2. Dispositif de dépôt selon la revendication 1, **caractérisé en ce que** ladite au moins une cible (14a) agencée en partie basse de la chambre correspond à une ou plusieurs cibles rotatives, de préférence selon un/des axes de rotation (40a) parallèles à un plan principal de fond de chambre (12).

3. Dispositif de dépôt selon la revendication 1 ou 2, **caractérisé en ce que** dans la direction de la hauteur (16), l'écartement (E) entre ladite au moins une cible (14a) agencée en partie basse de la chambre, et le fond de chambre (6), est inférieur à 20 mm.

4. Dispositif de dépôt selon l'une quelconque des revendications précédentes, **caractérisé en ce que** la structure d'appui (52) du système de rupture de court-circuit (50) comprend une barre d'appui (54) parallèle à un plan principal de fond de chambre (12).

5. Dispositif de dépôt selon l'une quelconque des revendications précédentes, **caractérisé en ce que** le fond de chambre (6) est équipé d'au moins une rampe d'injection de gaz (47a) dans la chambre de dépôt (2), et **en ce que** la structure d'appui (52) du système de rupture de court-circuit (50) comprend, associée à chaque rampe d'injection de gaz (47a), une portion d'appui (58) destinée à être déplacée au-dessus de la rampe d'injection (47a).

6. Dispositif de dépôt selon l'une quelconque des revendications précédentes, **caractérisé en ce que** les moyens (60) de mise en mouvement sont conçus pour déplacer en translation la structure d'appui (52) du système de rupture de court-circuit (50).

7. Dispositif de dépôt selon l'une quelconque des revendications précédentes, **caractérisé en ce que** les moyens (60) de mise en mouvement comprennent un vérin pneumatique, de préférence télescopique.

8. Dispositif de dépôt selon l'une quelconque des revendications précédentes, **caractérisé en ce que** le système de rupture de court-circuit (50) comprend un dispositif (70) de commande des moyens de mise en mouvement (60), le dispositif de commande (70) étant actionnable par un opérateur.

9. Dispositif de dépôt selon l'une quelconque des revendications précédentes, **caractérisé en ce qu'**il comprend un système (72) de détection de court-circuit entre ladite au moins une cible (14a) agencée en partie basse de la chambre, et le fond de chambre (6), et **en ce que** le système de détection (72) est relié au système de rupture de court-circuit (50) de manière à actionner automatiquement le dispositif de commande (70) des moyens de mise en mouvement (60), en cas de détection de court-circuit.

10. Dispositif de dépôt selon l'une quelconque des revendications précédentes, **caractérisé en ce que** les moyens de support de substrat (24) sont des moyens permettant de mettre des substrats (26) en déplacement à l'intérieur de la chambre de dépôt (2).

11. Dispositif de dépôt selon l'une quelconque des revendications précédentes, **caractérisé en ce que** la chambre de dépôt (2) comporte un premier compartiment (2a) dans lequel se trouve ladite au moins une cible (14a) agencée en partie basse de la chambre, ainsi qu'un second compartiment (2b) communiquant avec le premier et logeant au moins une cible (14b) agencée dans une partie haute de la chambre, les moyens de support de substrat (24) étant agencés sous ladite au moins une cible (14b) agencée en partie haute de la chambre.

12. Dispositif de dépôt selon l'une quelconque des revendications précédentes, **caractérisé en ce que** ladite au moins une cible (14a) agencée en partie basse de la chambre fait partie intégrante d'un bloc cible amovible (32a) comprenant un capot supérieur (36a) de fermeture de la chambre de dépôt (2).

13. Dispositif de dépôt selon la revendication précédente, **caractérisé en ce que** le bloc cible (32a) comprend des supports de cibles (34a) agencés entre le capot supérieur de fermeture (36a) et la/les cibles (14a) agencées en partie basse de la chambre.

14. Procédé de rupture d'un court-circuit dans un dispositif (1) de dépôt physique en phase vapeur selon l'une quelconque des revendications précédentes, **caractérisé en ce qu'**il comprend la mise en mouvement de la structure d'appui (52) dans l'espace (56) situé entre le fond de chambre (6) et la cible (14a), de manière à venir contacter le substrat (26) en position de court-circuit puis à le déplacer / le casser, de sorte qu'il ne se trouve plus en contact simultané avec la cible (14a) et le fond de chambre (6).

## Patentansprüche

1. Vorrichtung (1) zur physikalischen Gasphasenabscheidung, umfassend eine Abscheidungskammer (2), die teilweise durch einen Kammerboden (6) begrenzt ist, wobei die Vorrichtung ferner, in der Kammer untergebracht, Folgendes umfasst:
- Substratträgermittel (24); und
- mindestens ein Ziel (14a), das in einem unteren Teil der Kammer (2) zwischen den Substratträgermitteln (24) und dem Kammerboden (6) in Bezug auf eine Höhenrichtung (16) der Abscheidungsvorrichtung angeordnet ist,
**dadurch gekennzeichnet, dass** sie ferner ein Kurzschluss-Unterbrechungssystem (50) umfasst, das durch ein Substrat (26) ausgelöst werden kann, das heruntergefallen ist und sich in der Kurzschlussposition gleichzeitig in Kontakt mit dem Ziel (14a) und dem Kammerboden (6) befindet, wobei das Kurzschluss-Unterbrechungssystem (50) eine Struktur (52) zum Abstützen auf dem bzw. den Substraten (26), die möglicherweise in die Kurzschlussposition heruntergefallen sind, sowie Bewegungsmittel (60) für die Abstützstruktur (52) in einem Raum (56) umfasst, der zwischen dem Kammerboden (6) und dem Ziel (14a) liegt.

2. Abscheidungsvorrichtung nach Anspruch 1, **dadurch gekennzeichnet, dass** das mindestens eine Ziel (14a), das in dem unteren Teil der Kammer angeordnet ist, einem oder mehreren rotierenden Zielen entspricht, vorzugsweise entlang einer Rotationsachse/Rotationsachsen (40a), die parallel zu einer Hauptebene des Kammerbodens (12) verläuft/verlaufen.

3. Abscheidungsvorrichtung nach Anspruch 1 oder 2, **dadurch gekennzeichnet, dass** der Abstand (E) in der Höhenrichtung (16) zwischen dem mindestens einen Ziel (14a), das in dem unteren Teil der Kammer angeordnet ist, und dem Kammerboden (6) weniger als 20 mm beträgt.

4. Abscheidungsvorrichtung nach einem der vorhergehenden Ansprüche, **dadurch gekennzeichnet, dass** die Abstützstruktur (52) des Kurzschluss-Unterbrechungssystems (50) eine Stützstange (54) umfasst, die parallel zu einer Hauptebene des Kammerbodens (12) verläuft.

5. Abscheidungsvorrichtung nach einem der vorhergehenden Ansprüche, **dadurch gekennzeichnet, dass** der Kammerboden (6) mit mindestens einer Gaseinspritzrampe (47a) in die Abscheidungskammer (2) ausgestattet ist, und dass die Abstützstruktur (52) des Kurzschluss-Unterbrechungssystems (50), in Verbindung mit jeder Gaseinspritzrampe (47a), einen Abstützabschnitt (58) umfasst, der dazu bestimmt ist, oberhalb der Einspritzrampe (47a) bewegt zu werden.

6. Abscheidungsvorrichtung nach einem der vorhergehenden Ansprüche, **dadurch gekennzeichnet, dass** die Bewegungsmittel (60) so ausgebildet sind, dass sie die Abstützstruktur (52) des Kurzschluss-Unterbrechungssystems (50) verschiebbar bewegen.

7. Abscheidungsvorrichtung nach einem der vorhergehenden Ansprüche, **dadurch gekennzeichnet, dass** die Bewegungsmittel (60) einen pneumatischen Zylinder, vorzugsweise einen teleskopischen, umfassen.

8. Abscheidungsvorrichtung nach einem der vorhergehenden Ansprüche, **dadurch gekennzeichnet, dass** das Kurzschluss-Unterbrechungssystem (50) eine Steuervorrichtung (70) für die Bewegungsmittel (60) umfasst, wobei die Steuervorrichtung (70) von einem Bediener betätigt werden kann.

9. Abscheidungsvorrichtung nach einem der vorhergehenden Ansprüche, **dadurch gekennzeichnet, dass** sie ein System (72) zum Detektieren eines Kurzschlusses zwischen dem mindestens einen Ziel (14a), das in dem unteren Teil der Kammer angeordnet ist, und dem Kammerboden (6) umfasst, und dass das Detektionssystem (72) mit dem Kurzschluss-Unterbrechungssystem (50) verbunden ist, um im Falle einer Detektion eines Kurzschlusses automatisch die Steuervorrichtung (70) für die Bewegungsmittel (60) zu betätigen.

10. Abscheidungsvorrichtung nach einem der vorhergehenden Ansprüche, **dadurch gekennzeichnet, dass** die Substratträgermittel (24) Mittel sind, die es ermöglichen, die Substrate (26) in das Innere der Abscheidungskammer (2) zu verschieben.

11. Abscheidungsvorrichtung nach einem der vorhergehenden Ansprüche, **dadurch gekennzeichnet, dass** die Abscheidungskammer (2) ein erstes Kammerabteil (2a), in dem sich das mindestens eine Ziel (14a) befindet, das in dem unteren Teil der Kammer angeordnet ist, sowie ein zweites Kammerabteil (2b) enthält, das mit dem ersten in Verbindung steht und in dem mindestens ein Ziel (14b) untergebracht ist, das in einem oberen Teil der Kammer angeordnet ist, wobei die Substratträgermittel (24) unter dem mindestens einen Ziel (14b) angeordnet sind, das in dem oberen Teil der Kammer angeordnet ist.

12. Abscheidungsvorrichtung nach einem der vorhergehenden Ansprüche, **dadurch gekennzeichnet, dass** das mindestens eine Ziel (14a), das in dem unteren Teil der Kammer angeordnet ist, ein integraler Bestandteil eines entfernbaren Zielblocks (32a) ist, der eine obere Verschlussabdeckung (36a) für die Abscheidungskammer (2) umfasst.

13. Abscheidungsvorrichtung nach dem vorhergehenden Anspruch, **dadurch gekennzeichnet, dass** der Zielblock (32a) Zielträger (34a) umfasst, die zwischen der oberen Verschlussabdeckung (36a) und dem/den Zielen (14a) angeordnet sind, die in dem unteren Teil der Kammer angeordnet sind.

14. Verfahren zum Unterbrechen eines Kurzschlusses in einer Vorrichtung (1) zur physikalischen Gasphasenabscheidung nach einem der vorhergehenden Ansprüche, **dadurch gekennzeichnet, dass** es das Bewegen der Abstützstruktur (52) in dem Raum (56), der zwischen dem Kammerboden (6) und dem Ziel (14a) liegt, umfasst, um das Substrat (26) in der Kurzschlussposition zu kontaktieren und es dann zu bewegen/zu brechen, so dass es sich nicht mehr gleichzeitig in Kontakt mit dem Ziel (14a) und dem Kammerboden (6) befindet.

## Claims

1. A physical vapour deposition device (1), comprising a deposition chamber (2) partly delimited by a chamber bottom (6), the device further comprising, housed in the chamber:
- substrate support means (24); and
- at least one target (14a) arranged in a lower part of the chamber (2), between the substrate support means (24) and the chamber bottom (6) in relation to a direction of the height (16) of the deposition device,
**characterised in that** it further includes a short-circuit breaking system (50) capable of being caused by a substrate (26) which has fallen and is in a short-circuit position in simultaneous contact with the target (14a) and the chamber bottom (6), the short-circuit breaking system (50) comprising a structure (52) for supporting the possible substrate(s) (26) which has fallen into the short-circuit position, as well as means (60) for moving the support structure (52) in a space (56) located between the chamber bottom (6) and the target (14a).

2. The deposition device according to claim 1, **characterised in that** said at least one target (14a) arranged in the lower part of the chamber corresponds to one or more rotating targets, preferably along one or more axes of rotation (40a) parallel to a main plane of the chamber bottom (12).

3. The deposition device according to claim 1 or 2, **characterised in that** in the height direction (16), the spacing (E) between said at least one target (14a) arranged in the lower part of the chamber, and the chamber bottom (6), is less than 20 mm.

4. The deposition device according to any one of the preceding claims, **characterised in that** the support structure (52) of the short-circuit breaking system (50) comprises a support bar (54) parallel to a main chamber bottom plane (12).

5. The deposition device according to any one of the preceding claims, **characterised in that** the chamber bottom (6) is equipped with at least one ramp (47a) for injecting gas in the deposition chamber (2), and **in that** the support structure (52) of the short-circuit breaking system (50) comprises, associated with each gas injection ramp (47a), a support portion (58) intended to be moved above the injection ramp (47a).

6. The deposition device according to any one of the preceding claims, **characterised in that** the movement means (60) are designed to move the support structure (52) of the short-circuit breaking system (50) in translation.

7. The deposition device according to any one of the preceding claims, **characterised in that** the movement means (60) comprise a pneumatic cylinder, which is preferably telescopic.

8. The deposition device according to any one of the preceding claims, **characterised in that** the short-circuit breaking system (50) comprises a device (70) for controlling the movement means (60), the control device (70) being operable by an operator.

9. The deposition device according to any one of the preceding claims, **characterised in that** it comprises a system (72) for detecting a short circuit between said at least one target (14a) arranged in the lower part of the chamber, and the chamber bottom (6), and **in that** the detection system (72) is connected to the short-circuit breaking system (50) so as to automatically actuate the device (70) for controlling the movement means (60), in the event of detection of a short circuit.

10. The deposition device according to any one of the preceding claims, **characterised in that** the substrate support means (24) are means for moving substrates (26) inside the deposition chamber (2).

11. The deposition device according to any one of the preceding claims, **characterised in that** the deposition chamber (2) includes a first compartment (2a) wherein said at least one target (14a) is located, arranged in the lower part of the chamber, as well as a second compartment (2b) communicating with the first and housing at least one target (14b) arranged in an upper part of the chamber, the substrate support means (24) being arranged under said at least one target (14b) arranged in the upper part of the chamber.

12. The deposition device according to any one of the preceding claims, **characterised in that** said at least one target (14a) arranged in the lower part of the chamber forms an integral part of a removable target block (32a) comprising an upper cover (36a) for closing the deposition chamber (2).

13. The deposition device according to the preceding claim, **characterised in that** the target block (32a) comprises target supports (34a) arranged between the upper closing cover (36a) and the target(s) (14a) arranged in the lower part of the chamber.

14. A method for breaking a short circuit in a physical vapour deposition device (1) according to any one of the preceding claims, **characterised in that** it comprises moving the support structure (52) in the space (56) located between the chamber bottom (6) and the target (14a), so as to contact the substrate (26) in the short-circuit position and to move/break it, so that it is no longer in simultaneous contact with the target (14a) and the chamber bottom (6).
